# EUROPEAN PATENT SPECIFICATION

(11) **EP 3 639 306 B1**
(45) Date of publication and mention of the grant of the patent: **26.07.2023**
(21) Application number: 18738159.5
(22) Date of filing: 18.06.2018
(51) Int. Cl.: H10N 15/10

(54) **METHOD OF MAKING ELECTROCALORIC ARTICLES**
VERFAHREN ZUR HERSTELLUNG ELEKTROKALORISCHER ARTIKEL
PROCÉDÉ DE FABRICATION D'ARTICLES ÉLECTRO-CALORIQUES

(30) Priority: 16.06.2017 US 201762521175 P
(43) Date of publication of application: 22.04.2020
(73) Proprietor: Carrier Corporation, Palm Beach Gardens, FL 33418 (US)
(72) Inventor: SCHMIDT, Wayde R., East Hartford, CT 06108 (US); CULP, Slade R., East Hartford, CT 06108 (US); XIE, Wei, East Hartford, CT 06108 (US); MANTESE, Joseph V., East Hartford, CT 06108 (US); EASTMAN, Scott Alan, East Hartford, CT 06108 (US); ANNAPRAGADA, Subramanyaravi, East Hartford, CT 06108 (US); DARDONA, Sameh, East Hartford, CT 06108 (US); WALKER, Craig R., East Hartford, CT 06108 (US); VERMA, Parmesh, East Hartford, CT 06108 (US)
(74) Representative: Dehns
(86) International application number: PCT/US2018/038052
(87) International publication number: WO 2018/232393

(56) References cited:
- WO-A1-2017/030529
- WO-A1-2017/111921
- US-A1- 2014 199 473
- US-A1- 2016 225 775
- US-B1- 6 323 580
- ROAR R. SONDERGAARD ET AL: "Roll-to-Roll fabrication of large area functional organic materials", JOURNAL OF POLYMER SCIENCE PART B: POLYMER PHYSICS, vol. 51, no. 1, 19 October 2012 (2012-10-19), pages 16-34, XP055385201, US ISSN: 0887-6266, DOI: 10.1002/polb.23192
- KAIHOVIRTA N ET AL: "Printed all-polymer electrochemical transistors on patterned ion conducting membranes", ORGANIC ELECTRONICS, ELSEVIER, AMSTERDAM, NL, vol. 11, no. 7, 1 July 2010 (2010-07-01), pages 1207-1211, XP027074911, ISSN: 1566-1199, DOI: 10.1016/J.ORGEL.2010.04.025 [retrieved on 2010-06-03]
- IE S ET AL: "Amorphous indium tin oxide electrodes for piezoelectric and light-emitting device deposited by vacuum roll to roll process", THIN SOLID FILMS, ELSEVIER, AMSTERDAM, NL, vol. 517, no. 14, 29 May 2009 (2009-05-29) , pages 4015-4018, XP026094849, ISSN: 0040-6090, DOI: 10.1016/J.TSF.2009.01.186 [retrieved on 2009-02-10]

## Description

### BACKGROUND

A wide variety of technologies exist for cooling applications, including but not limited to evaporative cooling, convective cooling, or solid state cooling such as electrothermic cooling. One of the most prevalent technologies in use for residential and commercial refrigeration and air conditioning is the vapor compression refrigerant heat transfer loop. These loops typically circulate a refrigerant having appropriate thermodynamic properties through a loop that comprises a compressor, a heat rejection heat exchanger (i.e., heat exchanger condenser), an expansion device and a heat absorption heat exchanger (i.e., heat exchanger evaporator). Vapor compression refrigerant loops effectively provide cooling and refrigeration in a variety of settings, and in some situations can be run in reverse as a heat pump. However, many of the refrigerants can present environmental hazards such as ozone depleting potential (ODP) or global warming potential (GWP), or can be toxic or flammable. Additionally, vapor compression refrigerant loops can be impractical or disadvantageous in environments lacking a ready source of power sufficient to drive the mechanical compressor in the refrigerant loop. For example, in an electric vehicle, the power demand of an air conditioning compressor can result in a significantly shortened vehicle battery life or driving range. Similarly, the weight and power requirements of the compressor can be problematic in various portable cooling applications.

Accordingly, there has been interest in developing cooling technologies as alternatives to vapor compression refrigerant loops. Various technologies have been proposed such as field-active heat or electric current-responsive heat transfer systems relying on materials such as electrocaloric materials, magnetocaloric materials, or thermoelectric materials. However, many proposals have been configured as bench-scale demonstrations with limited capabilities and manufacturability.

WO 2017/030529 discloses a method for producing a cooling system including an electrocaloric element, a pair of electrodes is disposed on opposite surfaces of the electrocaloric element wherein the electrodes are prepared by applying an electrode forming ink to the electrocaloric element.

US 2016225775 discloses a method of producing a thin film ferroelectric device and depositing conductive material on opposing surfaces of the thin film.
"Printed all-polymer electrochemical transistors on patterned ion conducting membranes" by Kaihovirta et al. Organic Electrics, volume 11 (2010) pages 1207-1211 discloses a roll to roll method for manufacturing low-voltage all-polymer electrochemical transistors (ECT). The polymer forming the ECT is applied to a membrane of poly(vinylidene diflouoride) via flexography in which the ECT polymer is applied to a patterned roller and then transferred from the roller to the membrane.
"Amorphous indium tin oxide electrodes for piezoelectric and light-emitting device deposited by vacuum roll-to-roll process" by Ie et al. This Solid Films volume 517 pages 4015 to 4018 discloses a method of depositing indium tin oxide electrodes on organic light emitting diodes by first applying an indium tin oxide layer to the organic light emitting diode using a roll to roll sputter deposition method, and subsequently creating an electrode pattern within the deposited layer using laser ablation.

US 6 323 580 discloses a ferroic transducer made from, for example PVDF which can produce an electrocaloric effect, comprising interdigitated electrodes on a single side of the film, the electrodes may be spaced apart at equal distances, at approximately 10 times the thickness of the electrostatic film.

### BRIEF DESCRIPTION

In some embodiments of this disclosure, a method of making electrocaloric articles, comprises
(a) providing a roll of a film comprising an electrocaloric material or a supply of multiple sheets of a film comprising an electrocaloric material;
(b) delivering film from the roll or the supply of multiple sheets to a conductive material application station;
(c) forming electrodes comprising a patterned disposition of conductive material on the film at the application station to form an electrocaloric article, wherein forming electrodes at the application station comprises applying a patterned disposition of conductive material onto a temporary support and transferring the patterned disposition of conductive material from the temporary support to the film and wherein forming the patterned disposition of conductive material to the temporary support comprises:
   (i) selectively applying conductive material to a plurality of areas of the temporary support and the plurality of areas are spaced apart by a dimension of 0.1 times the film thickness to 10 times the film thickness,
   (ii) applying conductive material to a plurality of areas of the temporary support through a patterned mask, and removing the mask, wherein the plurality of areas are spaced apart by a dimension of 0.1 times the film thickness to 10 times the film thickness,
   (iii) selectively etching a conductive material on the temporary support to form a plurality of areas of conductive material spaced apart by a dimension of 0.1 times the film thickness to 10 times the film thickness, or
   (iv) applying conductive material to the temporary support, etching the conductive material through unmasked areas of a patterned mask, and removing the mask to form a plurality of areas of conductive material spaced apart by a dimension of 0.1 times the film thickness to 10 times the film thickness,
(d) delivering film from the application station to a take-up roll or an inventory of electrocaloric sheets; and
(e) repeating (b), (c), and (d) to form multiple electrocaloric articles.

In some embodiments of this disclosure, a method of making electrocaloric articles, comprises
(a) providing a roll of a film comprising an electrocaloric material or a supply of multiple sheets of a film comprising an electrocaloric material;
(b) delivering film from the roll or the supply of multiple sheets to a conductive material application station;
(c) forming electrodes comprising a patterned disposition of conductive material on the film at the application station to form an electrocaloric article wherein forming the patterned disposition of conductive material comprises:
   (i) selectively applying conductive material to a plurality of areas of the film and the plurality of areas are spaced apart by a dimension of 0.1 times the film thickness to 10 times the film thickness,
   (ii) applying conductive material to a plurality of areas of the film through a patterned mask, and removing the mask wherein the plurality of areas are spaced apart by a dimension of 0.1 times the film thickness to 10 times the film thickness,
   (iii) selectively etching a conductive material on the film to form a plurality of areas of conductive material spaced apart by a dimension of 0.1 times the film thickness to 10 times the film thickness, or
   (iv) etching a conductive material on the film through unmasked areas of a patterned mask, and removing the mask to form a plurality of areas of conductive material spaced apart by a dimension of 0.1 times the film thickness to 10 times the film thickness,
(d) delivering film from the application station to a take-up roll or an inventory of electrocaloric sheets; and
(e) repeating (b), (c), and (d) to form multiple electrocaloric articles.

In some embodiments, the patterned disposition of conductive material can include a power connection configured to connect to an electrical connection between a power source and the electrodes.

According to any one or combination of the above embodiments, forming electrodes at the application station can comprise forming first and second electrodes on the same side of the film.

In some embodiments, forming electrodes at the application station can comprise forming first and second electrodes on opposite sides of the film.

In some embodiments, applying conductive material can include ion implanted doping, ion implanted electrically active defects, or electron beam induced electrically active defects.

In some embodiments, the plurality of areas on the electrocaloric film surface comprising the conductive material can be configured as a plurality of electrically connected linear extensions of conductive material along the film surface separated by spacer areas.

In some embodiments, the plurality of areas on the electrocaloric film surface comprising the conductive material spacer areas can be spaced apart by a dimension of 0.2 times the film thickness to 5 times the film thickness.

In some embodiments, the plurality of areas on the electrocaloric film surface comprising the conductive material can be spaced apart by a dimension of 0.5 times the film thickness to 2 times the film thickness.

In some embodiments, a method of making an electrocaloric module comprises making an electrocaloric article according to any one or combination of the above embodiments, and disposing the electrocaloric article in an electrocaloric module comprising the electrocaloric article, a first thermal connection configured to connect to a first thermal flow path between the electrocaloric article and a heat sink, a second thermal connection configured to connect to a second thermal flow path between the electrocaloric article and a heat source, and a power connection connected to the electrodes and configured to connect to a power source.

In some embodiments, the method of making an electrocaloric module can further comprise disposing a plurality of the electrocaloric articles in electrocaloric module in a stack configuration.

In some embodiments, a method of making an electrocaloric heat transfer system comprises making an electrocaloric module according to any of the above embodiments and connecting the first thermal connection to a first thermal flow path between the electrocaloric article and a heat sink, connecting the second thermal connection to a second thermal flow path between the electrocaloric article and a heat source, connecting the power connection to a power source, and connecting a controller configured to selectively apply voltage to activate the electrodes in coordination with heat transfer along the first and second thermal flow paths to transfer heat from the heat source to the heat sink.

### BRIEF DESCRIPTION OF THE DRAWINGS

Subject matter of this disclosure is particularly pointed out and distinctly claimed in the claims at the conclusion of the specification. The foregoing and other features, and advantages of the present disclosure are apparent from the following detailed description taken in conjunction with the accompanying drawings in which:
FIG. 1 is a graphical depiction of an example embodiment of the methods described herein;
FIG. 2 is a schematic depiction of an electrocaloric module from the view of FIG. 2;
FIG. 3A is a schematic depiction of a top view of patterned electrodes in an interdigitated configuration, FIG. 3B represents a schematic depiction of cross-section side view of the electrodes on opposite sides of an electrocaloric film, and FIG. 3C represents a schematic depiction of cross-section side view of the electrodes on the same side of an electrocaloric film; and
FIGS. 4A, 4B, and 4C, each represents a schematic depiction of a different pattern configuration for patterned electrodes;
FIG. 5 is a schematic depiction of an example embodiment of an electrocaloric heat transfer system;
FIG. 6 is a schematic depiction of roll-to-roll manufacturing; and
FIG. 7 is a schematic depiction of sheet manufacturing.

### DETAILED DESCRIPTION

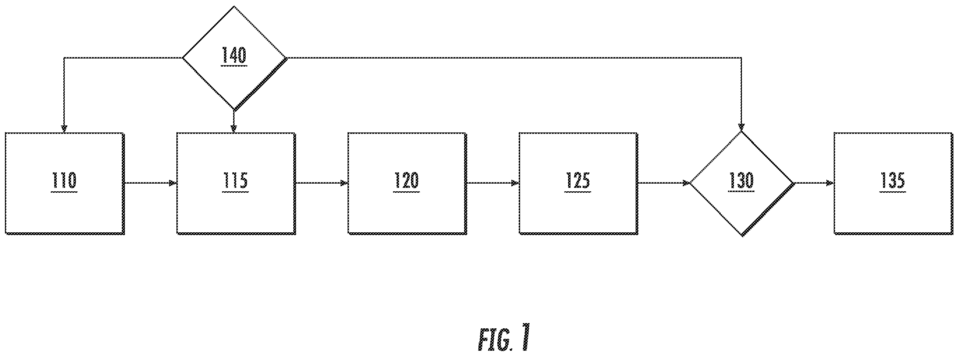

With reference now to the Figures, FIG. 1 is a graphical depiction in flow chart format of an example embodiment of the methods described herein. As shown in FIG. 1, block 110 of the flow chart involves provision of a roll of a film comprising an electrocaloric material or a supply of multiple sheets of a film comprising an electrocaloric material. The electrocaloric film can be supplied to the process from another process such as an inventory system that acquires film supply from outside sources or from a film manufacturing process The electrocaloric film can comprise any of a number of electrocaloric materials. In some embodiments, electrocaloric film thickness can be in a range having a lower limit of 0.1 nm, more specifically 0.5 nm, and even more specifically 1 nm. In some embodiments, the film thickness range can have an upper limit of 1000 µm, more specifically 100 µm, and even more specifically 10 µm. It is understood that these upper and lower range limits can be independently combined to disclose a number of different possible ranges. Examples of electrocaloric materials for the electrocaloric film can include but are not limited to inorganic materials (e.g., ceramics), electrocaloric polymers, and polymer/ceramic composites. Examples of inorganics include but are not limited to PbTiOs ("PT"), Pb(Mg_{1/3}Nb_{2/3})O₃ ("PMN"), PMN-PT, LiTaO₃, barium strontium titanate (BST) or PZT (lead, zirconium, titanium, oxygen). Examples of electrocaloric polymers include, but are not limited to ferroelectric polymers, liquid crystal polymers, and liquid crystal elastomers.

Ferroelectric polymers are crystalline polymers, or polymers with a high degree of crystallinity, where the crystalline alignment of polymer chains into lamellae and/or spherulite structures can be modified by application of an electric field. Such characteristics can be provided by polar structures integrated into the polymer backbone or appended to the polymer backbone with a fixed orientation to the backbone. Examples of ferroelectric polymers include polyvinylidene fluoride (PVDF), polytriethylene fluoride, odd-numbered nylon, copolymers containing repeat units derived from vinylidene fluoride, and copolymers containing repeat units derived from triethylene fluoride. Polyvinylidene fluoride and copolymers containing repeat units derived from vinylidene fluoride have been widely studied for their ferroelectric and electrocaloric properties. Examples of vinylidene fluoride-containing copolymers include copolymers with methyl methacrylate, and copolymers with one or more halogenated co-monomers including but not limited to trifluoroethylene, tetrafluoroethylene, chlorotrifluoroethylene, trichloroethylene, vinylidene chloride, vinyl chloride, and other halogenated unsaturated monomers.

Liquid crystal polymers, or polymer liquid crystals comprise polymer molecules that include mesogenic groups. Mesogenic molecular structures are well-known, and are often described as rod-like or disk-like molecular structures having electron density orientations that produce a dipole moment in response to an external field such as an external electric field. Liquid crystal polymers typically comprise numerous mesogenic groups connected by non-mesogenic molecular structures. The non-mesogenic connecting structures and their connection, placement and spacing in the polymer molecule along with mesogenic structures are important in providing the fluid deformable response to the external field. Typically, the connecting structures provide stiffness low enough so that molecular realignment is induced by application of the external field, and high enough to provide the characteristics of a polymer when the external field is not applied.

In some exemplary embodiments, a liquid crystal polymer can have rod-like mesogenic structures in the polymer backbone separated by non-mesogenic spacer groups having flexibility to allow for re-ordering of the mesogenic groups in response to an external field. Such polymers are also known as main-chain liquid crystal polymers. In some exemplary embodiments, a liquid crystal polymer can have rod-like mesogenic structures attached as side groups attached to the polymer backbone. Such polymers are also known as side-chain liquid crystal polymers.

With reference again to FIG. 1, in block 115, the film is delivered from the roll or the supply of multiple sheets to a conductive material application station. From there, the process flow proceeds to block 120, where electrodes are applied to film surface(s) at the conductive material application station to form an electrocaloric article. The electrodes comprise a patterned disposition of conductive material. The process flow then proceeds to block 125, in which the film is delivered from the application station to a take-up roll or an inventory of electrocaloric sheets. The process flow then proceeds to decision block 130, in which a query is posed as to whether there is system demand for additional articles. If the answer is no, the process flow proceeds to block 135 where a process stop can be implemented. If the answer is yes, the process flow proceeds to decision block 140, in which a query is posed as to whether there is adequate supply of film for continued manufacture of electrocaloric articles. If the answer is yes, the process flow proceeds to block 125 for delivery of more film to the conductive material application station. If the answer is no, then the process flow proceeds to block 120 for provision of additional film.

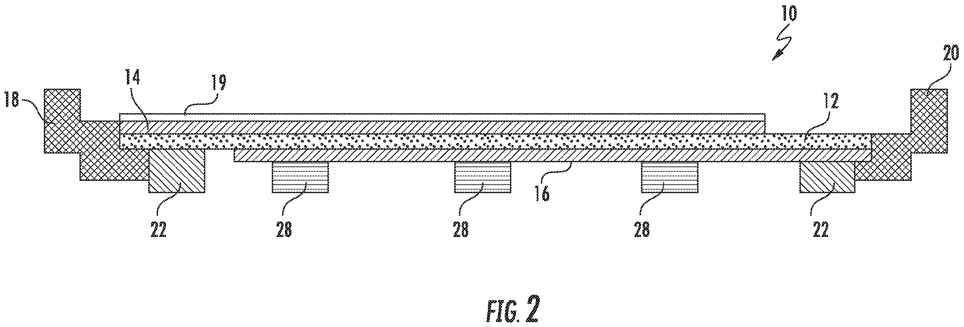

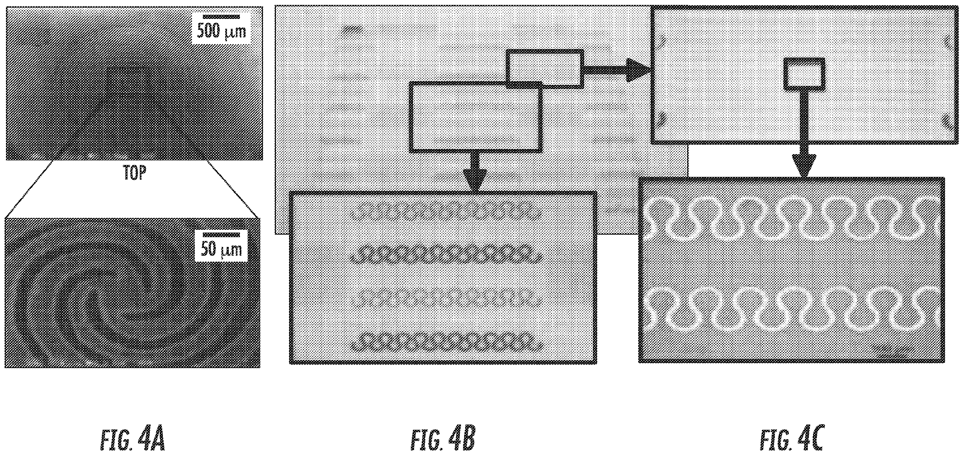

As mentioned above, a patterned disposition of conductive material is applied at a conductive material application station to form electrode(s) on the film. With reference now to FIG. 2, a side view of an electrocaloric article is schematically depicted. As shown in FIG. 2, first electrode 14 is electrically connected to a first electrical bus element 18. Similarly, second electrode 16 is electrically connected to second electrical bus element 20. The electrodes can be any type of conductive material as described in greater detail below, including but not limited to metallized layers of a conductive metal such as aluminum or copper, or other conductive materials such as carbon (e.g., carbon nanotubes, graphene, or other conductive carbon). Noble metals can also be used, but are not required. Other conductive materials such as a doped semiconductor, ceramic, or polymer, or conductive polymers can also be used. The electrodes 14 and 16 shown in FIG. 4 can extend from a position in contact with an electrical bus element on one edge of the film and extend across the film to a position that is not in contact with the electrical bus element of opposite polarity on the other edge of the film 12. Thus, the first electrode 14 is electrically connected to a first electrical bus element 18. Similarly, second electrode 16 is electrically connected to second electrical bus element 20. The bus elements include a power connection (not shown) configured to an electric power source (not shown).

With reference again to FIG. 2, one or more support elements 22 can optionally be included for support and retention of the electrocaloric element. However, separate support elements are not required, as support and retention can also be provided by the bus elements as shown in FIG. 2 described below. Although not required in all design configurations, in some embodiments, the support elements can be made from an electrically non-conductive material. Spacer elements 28 can optionally be included to help maintain separation from adjacent electrocaloric elements for a fluid flow path for a working fluid (e.g., either a fluid to be heated or cooled directly such as air, or a heat transfer fluid such as a dielectric organic compound). Any configuration of spacer elements can be utilized, such as a set of discrete disk spacer elements or linear or non-linear axially extending spacer elements

At least one of the electrodes, and in some embodiments both of the electrodes 14 and 16 comprise a patterned disposition of conductive material on the surface of electrocaloric film 12. In some embodiments, the patterned disposition can comprise a plurality of areas on the electrocaloric film surface comprising the conductive material separated by non-conductive spacer areas on the electrocaloric film. In some embodiments, the spacing between areas comprising the conductive material can be in a range with a low end of 0.1 times the film thickness, or 10 times the film thickness, or 0.2 times the film thickness, and an upper end of 5 times the film thickness, or 0.5 times the film thickness, or 2 times the film thickness. In some embodiments, such spacing can provide a technical effect of promoting distribution through the electrocaloric film of an electric field formed when the electrodes are powered. In some embodiments, electrode(s) comprising a patterned disposition of conductive material can optionally have a protective layer over the electrode (e.g., a polymer protective or barrier layer) such as the protective layer 19 shown in FIG. 2. In some embodiments, a protective layer can provide a protective barrier to inhibit moisture or other contaminants from reaching the electrode(s) and/or promote resistance to electrical arcing.

In some embodiments, the electrode(s) can be configured as a plurality of electrically connected linear extensions of conductive material along the film surface separated by non-conductive spacer areas on the electrocaloric film. In other words, the non-conductive spacer areas provide a locally non-conductive area, but are not so extensive as to electrically isolate the extensions from each other. In some embodiments, the spacing between adjacent linear extensions as a function of film thickness can be in any of the above ranges. In some embodiments, the patterned electrodes can provide a technical effect of promoting the accommodation of stress and strain resulting from electrostrictive effects on the electrocaloric film that can accompany the entropy changes in the material that produce the electrocaloric effect. Several example embodiments of configurations are described below with respect to certain electrode configurations (e.g., linear extensions of conductive material along the film surface separated by spacer areas on the electrocaloric film), but the above-described technical effects are not limited to such configurations, as discussed further below.

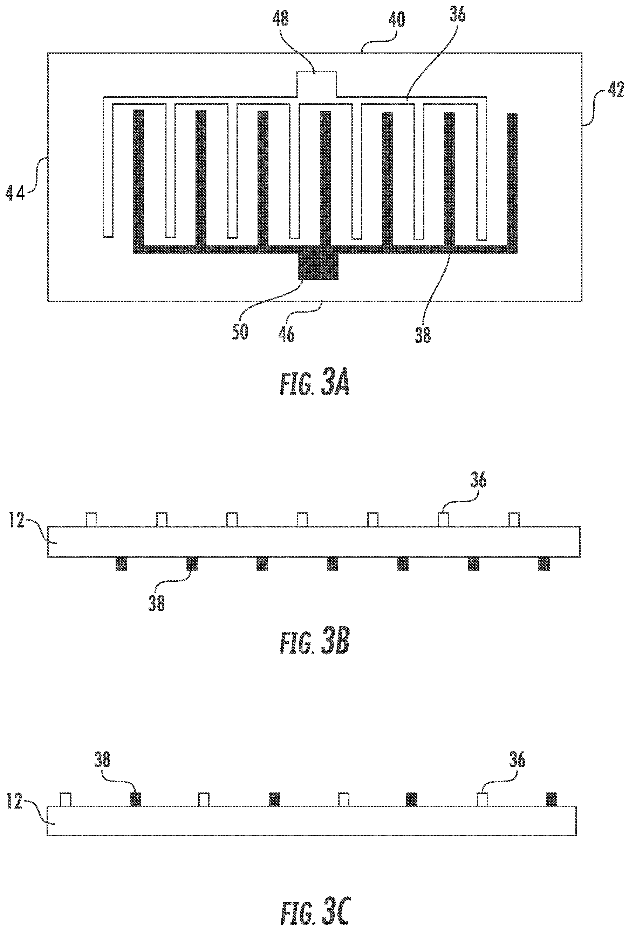

An example embodiment of electrodes comprising linear extensions of conductive material is schematically shown in FIGS. 3A, 3B, and 3C. As shown in FIG. 3A, electrodes 36 and 38 are shown in a top view on electrocaloric film 12 having edges 40, 42, 44, and 46. Electrical connectors 48 and 50 provide a connection to a power source and/or controller (not shown). The electrodes 36 and 38 (and thus the first and second film surfaces on which the electrodes are disposed) can be on the same side of the electrocaloric film 12 as shown in FIG. 3C, or on opposite sides of the electrocaloric film 12 as shown in FIG. 3B. As shown in FIGS. 3A-3C, unnumbered spacer areas of film surface free of the electrode material are interposed between the electrode fingers, and spacing between the fingers can be set with respect to the film thickness in any of the ranges described above.

In some embodiments, electrode linear extensions can extend in a direction along the film surface perpendicular to a stress or strain vector on the electrocaloric film during operation. For example, the example embodiment of FIG. 3A shows electrodes extending in a direction perpendicular to a stress or strain vector in a direction between the film edges 42 and 44 In some embodiments (for example in embodiments in which an electrocaloric element is supported on two opposing edge segments, but not on edge segments perpendicular to the supported edges), stress or strain can be incurred by an electrocaloric element in a direction perpendicular to the direction of a shortest line between the supported edges, in which case the electrode linear extensions can extend in a direction parallel to the shortest line between the supported edges. Of course, the supported edge can extend partly around the edge of the electrocaloric film or completely around the edge of the electrocaloric film, and stress or strain can occur along multiple vectors.

The electrode linear extensions shown in FIG. 3A comprise straight finger-like projections, but many other configurations can be used. Curved or complex shaped linear extensions can be used to accommodate a variety of stress/strain patterns that an electrocaloric may be subjected to during operation. In some embodiments, the linear extensions can include interconnecting features that can maintain electrical connection between the linear extensions if a section of the linear section is damaged. Several example embodiments of electrode patterns are shown in a top view in FIGS. 4A, 4B, and 4C. Each of FIGS. 4A, 4B, and 4C shows a lower-magnification upper image and a higher-magnification lower image of example embodiments of curved or complex-shaped linear extensions. In some embodiments curved or complex shaped linear extensions can provide a technical effect of promoting the accommodation of stress or strain in multiple directions, and in some embodiments can promote the accommodation of stress or strain from any direction (i.e., omnidirectional). Other electrode pattern configurations can be used besides spacer area-separated linear extensions. For example, a thickness variation of the electrode conductive material in a direction normal to the film surface (which can be repeated across the surface) can provide a configuration with a wave-like structure or pattern that can absorb stress or strain in a direction along (parallel to) the film surface. Also, alternative embodiments could include electrodes configured with a pattern of an otherwise contiguous metallization field with spacer areas of circular, ovular, polygonal, or other shapes randomly or regularly placed in the metallization field.

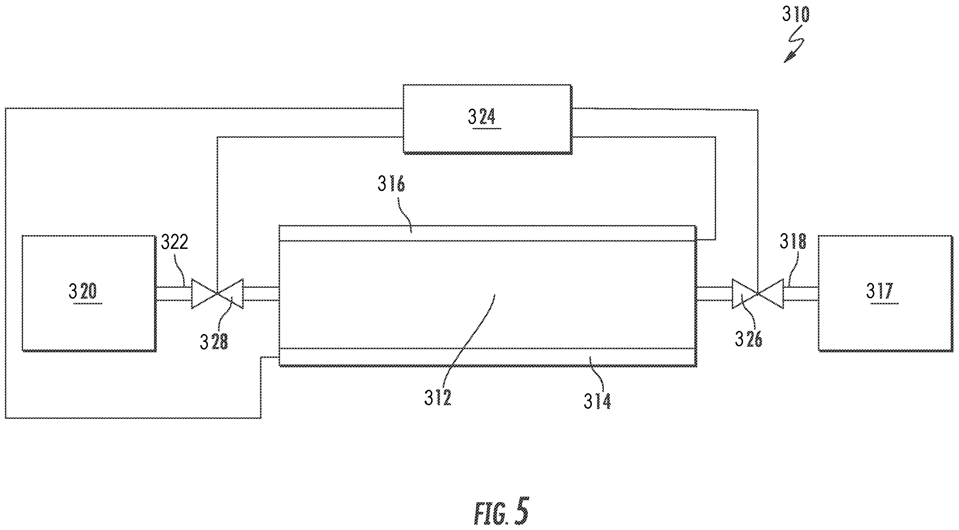

In some embodiments, electrocaloric articles such as described above can be incorporated into an electrocaloric heat transfer system. An example embodiment of an electrocaloric heat transfer system is schematically depicted in FIG. 5. As shown in FIG. 5, a heat transfer system 10 comprises an electrocaloric module comprising an electrocaloric film 12 having electrodes 14 and 16 on opposite surfaces thereof. Multiple electrocaloric elements configured in a stack can also be used. The electrocaloric element is in thermal communication with a heat sink 17 through a first thermal flow path 18 connected through a first thermal connection on the module, and in thermal communication with a heat source 20 through a second thermal flow path 22 connected through a second thermal connection on the module. The thermal flow paths are described below with respect to thermal transfer through flow of a heat transfer fluid through control valves 26 and 28 between the electrocaloric element and the heat sink and heat source, but can also be through conductive heat transfer through solid state heat thermoelectric switches in thermally conductive contact with the electrocaloric element and the heat source or heat sink, or thermomechanical switches in movable to establish thermally conductive contact between the electrocaloric element and the heat source or heat sink. A controller 24 is configured to control electrical current to through a power source (not shown) to selectively activate the electrodes 14, 16 through a power connection on the module connected to the electrodes. The controller 24 is also configured to open and close control valves 26 and 28 to selectively direct the heat transfer fluid along the first and second flow paths 18 and 22.

In operation, the system 10 can be operated by the controller 24 applying an electric field as a voltage differential across the electrocaloric element to cause a decrease in entropy and a release of heat energy by the electrocaloric elements. The controller 24 opens the control valve 26 to transfer at least a portion of the released heat energy along flow path 18 to heat sink 17. This transfer of heat can occur after the temperature of the electrocaloric elements has risen to a threshold temperature. In some embodiments, heat transfer to the heat sink 17 is begun as soon as the temperature of the electrocaloric elements increases to be about equal to the temperature of the heat sink 17. After application of the electric field for a time to induce a desired release and transfer of heat energy from the electrocaloric elements to the heat sink 17, the electric field can be removed. Removal of the electric field causes an increase in entropy and a decrease in heat energy of the electrocaloric elements. This decrease in heat energy manifests as a reduction in temperature of the electrocaloric elements to a temperature below that of the heat source 20. The controller 24 closes control valve 26 to terminate flow along flow path 18, and opens control device 28 to transfer heat energy from the heat source 20 to the colder electrocaloric elements in order to regenerate the electrocaloric elements for another cycle.

In some embodiments, for example where a heat transfer system is utilized to maintain a temperature in a conditioned space or thermal target, the electric field can be applied to the electrocaloric elements to increase its temperature until the temperature of the electrocaloric element reaches a first threshold. After the first temperature threshold, the controller 24 opens control valve 26 to transfer heat from the electrocaloric elements to the heat sink 17 until a second temperature threshold is reached. The electric field can continue to be applied during all or a portion of the time period between the first and second temperature thresholds, and is then removed to reduce the temperature of the electrocaloric elements until a third temperature threshold is reached. The controller 24 then closes control valve 26 to terminate heat flow transfer along heat flow path 18, and opens control valve 28 to transfer heat from the heat source 20 to the electrocaloric elements. The above steps can be optionally repeated until a target temperature of the conditioned space or thermal target (which can be either the heat source or the heat sink) is reached.

As mentioned above, various types of conductive materials can be applied in a patterned configuration, including but not limited to metals, carbon, or doped semiconductors, ceramics, or polymers. Various types of application techniques can be used. For example, any of the above conductive materials can be applied in a liquid phase or powder phase, for example by processing the conductive material into pigment-sized particles and incorporating into an ink, powder coating composition, or other liquid coating composition that can be applied with various techniques including but not limited to jet (e.g., inkjet), spray, aerosol, mist, or dipping. Application of conductive material through such application techniques can also be used to apply a reactant or activator species (which is itself not necessarily conductive that reacts or interacts with a functional species or group in the film to form a conductive material at the film surface.

The electrodes can be any type of conductive material, including but not limited to metallized layers of a conductive metal such as aluminum or copper, or other conductive materials such as carbon (e.g., carbon nanotubes, graphene, or other conductive carbon). Noble metals can also be used, but are not required. Other conductive materials such as a doped semiconductor, ceramic, or polymer, or conductive polymers can also be used. Dopants can be utililized to create a conductive layer at or near the surface of a material, and can be incorporated during electrocaloric material synthesis. Doping can be achieved by gradually or abruptly increasing the donor or acceptor concentration through the addition of elements or components into a vapor, liquid, or powder phase during synthesis. Activation of the donor or acceptors can be achieved during synthesis or after synthesis such as with a post-fabrication thermal process.

In some embodiments, an electrically conductive surface modification can comprise an electrically conductive cladding or surface layer that is compatible with the underlying electrocaloric material. If the electrocaloric material comprises an electrocaloric ceramic composition, the compatible conductive cladding or surface layer comprises an electrically-conductive ceramic composition. The ceramic cladding or surface layer composition can include dopants to provide or enhance electrical conductivity, and can include other compositional variations from the underlying electrocaloric material for various purposes such as to enhance the electrical conductive effect of the dopant(s). The cladding or surface layer can be applied as a green ceramic tape that is co-formed as an outermost surface tape layer with other green ceramic tapes for the electrocaloric material, followed by sintering. Similarly with polymeric electrocaloric compositions, a cladding or surface layer can include an electrically-conductive polymer (including polymers with electrical conductivity-producing substituents) that is co-extruded with a base support of electrocaloric polymer. The polymeric cladding or surface layer composition can include dopants and/or substituents on the polymer molecule to provide or enhance electrical conductivity, and can include other compositional variations from the underlying electrocaloric material for various purposes such as to enhance the electrical conductive effect of the dopant(s). Examples of compositional pairings of electrocaloric material and cladding include lanthanum strontium chromite or lanthum strontium cobalt, lanthanum doped strontium titanate, etc.

In some embodiments in which the electrocaloric material comprises an electrocaloric polymer, an electrode can be provided by an atomic or molecular surface modification can comprise substituent(s) covalently or ionically bonded to electrocaloric polymer molecules at the surface of the material. The substituents can include electron donor and/or electron acceptor groups to provide an electrical conductive effect. Examples of potential substituents include N, Si, As, Sb, Bi. Combinations of substituents can be used to further enhance the electrical conductive effect. Selective chemical bonding of electrical conductivity-inducing substituents at the surface of the electrocaloric material can be accomplished by introducing the substituted polymer molecules during fabrication. Chemical bonding can be accomplished by introducing electrically conductive polymer molecules during at a location of fabrication of a surface portion of the electrocaloric material. Alternatively, a functional group can be included bonded to the polymer molecule that can be reacted or displaced (e.g., with wet or vapor chemistry) or converted (e.g., by heat or light) to form a conductivity-enhancing group bonded to the polymer molecule at the exposed surface of the electrocaloric material.

Vapor deposition can also be used to apply the conductive material. Vapor deposition techniques can include physical vapor deposition or chemical vapor deposition techniques. Examples of physical vapor deposition techniques include but are not limited to sputtering, where a target material is subject to a plasma discharge that is magnetically localized around or focused toward the target, causing some of the target to be ejected as a vapor and deposited onto the film. Electron beam physical vapor deposition can also be used, where target is bombarded with an electron beam given off by a charged tungsten filament under a vacuum, causing vaporization of the target material and coating metal onto the film also positioned in the vacuum chamber. Pulsed laser deposition (PLD) bombards a target in a vacuum chamber with high-powered laser pulses, resulting in a vaporized plasma plume from the target being deposited onto the film. Other techniques such as cathodic arc deposition or evaporative deposition can also be used. Chemical vapor deposition (CVD) techniques can also be used for depositing metal layers (e.g., aluminum, copper), conductive carbon layers such as graphene or carbon nanotubes, or semiconductors (e.g., polysilicon) that can be doped to provide the electrical conductivity needed for electrodes.

Plasma deposition and other thermal spray techniques can also be used to apply conductive material. Plasma spray involves introducing the feed material into a plasma jet emanating from a plasma torch and directed toward the substrate. A variant on plasma spray, known as vacuum plasma spray, is performed under low pressure and/or inert gas to minimize any by-products and minimize any process-induced oxidation of the coating materials. Flame spray introduces a feed stream material into a high-temperature combustion flame directed toward the substrate. Another alternative is high velocity oxygen fuel spraying (HVOF), where a fuel such as acetylene and oxygen are streamed together toward the substrate and ignited, and the feed stream is introduced into the combustion stream. Other thermal spray techniques include high velocity air fuel (HVAF), detonation spray coating (DSC), cold spray, or electric arc spray (e.g., twin wire arc spray).

Electrodeposition techniques such as electrophoresis, electroplating, or electrostatic spraying, can also be used to deposit conductive material. Electrophoresis, in which electrically active species are drawn to the film by a charged electrode on an opposite side of the film, can be applied to non-conductive electrocaloric materials directly, while other electrodeposition techniques can rely on a pre-treatment functionalization step in which the film surface is rendered receptive to electrodeposition. Chemistry techniques such as electroless plating, or nucleophilic or ionic reactions with polymer functional groups in a polymer film, can also be used to deposit conductive material. As mentioned above, application of conductive material to the film can be applied directly as a conductive material or as any other material (not necessarily conductive by itself) that renders the film surface conductive.

Ion implantation can also be used to deposit conductive material by depositing ions that can function as charge carriers (either electrons or holes). Ion implantation can be carried out by forming positive or negative ions with electron bombardment of a gas comprising ionizable atoms or molecules, and electromagnetically accelerating and focusing the ions into a beam directed onto a target substrate. A magnetic separator and aperture interposed in the beam can limit the ions passing through the separator to those of target mass and energy/charge values. The energy of the ions and their composition and that of the target will determine the depth of ion penetration into the target. In some embodiments, the penetration depth can range from 10 nm to 1 µm. Ions gradually lose their energy as they travel through the solid electrocaloric material, both from occasional collisions with target atoms and from drag due to overlap of electron orbitals. In some embodiments, the loss of ion energy in the target can prevent the ions from penetrating through the electrocaloric material. In some embodiments, the ion energy of the ion beam can be in a range having a low end of 1keV, 5 keV, or 10 keV, and an upper end of 500 keV, 250 keV, 150 keV or 100 keV. The above upper and lower range endpoints can be independently combined to disclose a number of different ranges, each of which is hereby explicitly disclosed. The loading quantity of ions implanted into the electrocaloric material can be controlled by factors such as the duration of exposure of the material to the ion beam. In some embodiments, ion implantation can provide an ion implantation dose in a range with a low end of 1×10¹⁷ ions/cm², 1×10¹⁸ ions/cm², or 1×10¹⁹ ions/cm², and an upper end of 1×10²⁰ ions/cm², 1×10²¹ ions/cm², or 1×10²² ions/cm². The above upper and lower range endpoints can be independently combined to disclose a number of different ranges, each of which is hereby explicitly disclosed. Ion implantation can be implemented with either polymeric or ceramic electrocaloric materials. In some embodiments, the implanted ion species can be selected to substitute for the A ion in an ABO₃ perovskite structure or ionic group in the electrocaloric material. Examples of ion source materials and corresponding ions implanted include, but are not limited to La, Mn, Nb, Ta, V, Mg. Additional disclosure regarding the use of ion implantation to deposit conductive material may be found in WO 2018/232392.

Energetic ions can also be utilized to penetrate into the surface of a material to produce electrically active defects. Implantation with heavy ions such as Ar can produce local defects due to disassociation or polymer chain breakage. These point and extended defects can often times be sufficiently electronically active to produce surface conductivity. Electron beams can be similarly used to create point and extended defects in both polymeric and ceramic materials at the surface. The depth of penetration of the damage zone is energy and material specific. While electron based surface modification can result in loss of oxygen or other atomic constituents in ceramic materials, its effect on polymers tends toward cross-linking of the polymer chains and many times graphitization of the surface, thereby resulting in a conductive surface. Such defects can be formed by exposing the electrocaloric surface to an electron beam, producing electrical conductivity primarily through the electronically active effect of defects in the molecular structure resulting from impact by electrons.

Patterning of the applied conductive material can be performed in various ways. In some embodiments, the application technique can provide for sufficient precision so that the conductive material is selectively applied, e.g., by a precision-directed application through jet or spray application of a liquid composition, or a precision-directed directed vapor deposition stream or thermal spray stream. As used herein, the term "selectively applied" means that the conductive material is applied onto the film in a non-uniform fashion. In some embodiments, selective application can comprise applying portions of the film designated for electrodes, and not applying the conductive material to portions of the film designated as non-conductive spacer areas. In some embodiments, and optionally in combination with the above-described electrode/spacer configuration, selective application can comprise applying the conductive material with a thickness variation (which can be repeated) in a direction normal to the film surface.

In some embodiments, patterning of the applied conductive material comprise applying the conductive material to the film through a mask. In some embodiments, the mask can have a shape configuration that is a negative of the desired configuration of the electrode(s) (e.g., a negative of the electrode shapes shown in FIGS. 3 and 4). Masks can be conventional photolithographic style in which a removable mask material is temporarily adhered to the film or placed into direct contact with the film, or shadow masks in which the mask is positioned with some distance between the mask and the film. Photolithographic-style masks can be used with any of the above techniques. Shadow masks can be used with any technique that directs a stream of material or energy toward the film, including but not limited to vapor deposition, plasma or other thermal spray depositions, ion implantation, or liquid or powder jet or spray deposition. Shadow masks can provide some in-process aiming capability by changing the angle of the stream with respect to the mask openings. Other patterning techniques can be used to achieve a patterned application of conductive material, such as applying a patterned functionalization to the film for chemical application of or conversion to conductive material, or applying a patterned deactivator such as a non-conductive surface pretreatment to prevent electrodeposition of material according to a pattern of applied non-conductive surface pretreatment.

Patterning can also be provided in post-deposition processing of applied conductive material on the film. In some embodiments, conductive material can be applied by any of the above techniques or any other technique to a field area on the film and then subjected to patterned removal to produce the patterned electrode. Etching can be performed selectively with precision-aimed etching beams or streams (e.g., laser beams, ion beams, electron beams) to for patterned removal of conductive material, or can be performed through a mask (either a photolithographic style or a shadow mask). Mechanical etching can also be used in some embodiments.

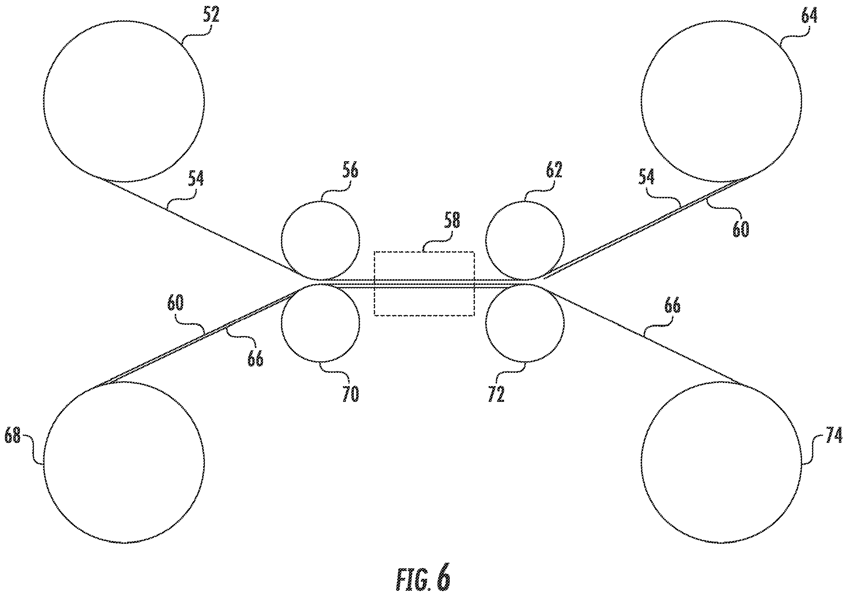

Turning now to FIG. 6, the figure schematically shows a roll manufacturing process and apparatus. As shown in FIG. 6, a supply roll 52 of film 54 is guided by a roller 56 to a conductive material application station 58 where a patterned conductive material is applied by any of the above-described techniques. The film 54 with patterned conductive material 60 thereon is guided from the conductive material application station 58 by roller 62 to a take-up roll 64. In some optional embodiments, the patterned conductive material can be first applied to a temporary support (e.g., a transfer film) at a second conductive material application station (not shown) by any of the above-described techniques and transferred to the film 54 at the conductive material application station 58. This optional embodiment is also shown in FIG. 1, in which transfer film 66 with patterned conductive material 60 thereon is guided from transfer film roll 68 to the conductive material application station 58 by roller 70. The patterned conductive material 60 is transferred to the electrocaloric film 54 and guided to take-up roll 64. The now barren transfer film is guided by roller 72 to transfer film take-up roll for reuse or recycling.

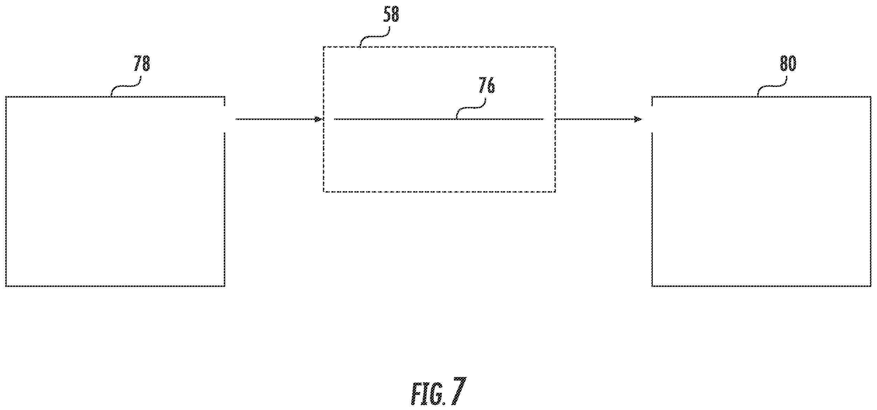

FIG. 7 schematically shows a sheet manufacturing process and apparatus. As shown in FIG. 7, a sheet feeder 78 containing a supply of sheets dispenses one or more sheets 76 in the direction of the unnumbered arrow to the conductive material application station 58. As with the roll embodiment of FIG. 6, any of the above methods (including transfer) can be used with sheet(s) 76 to apply patterned conductive material. A sheet ejector (not shown) integrated with the conductive material application station 58 directs the sheet(s) to a sheet inventory 80.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions or equivalent arrangements not heretofore described, but which are commensurate with the scope of the appended claims. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

## Claims

1. A method of making electrocaloric articles, comprising
(a) providing a roll (52) of a film (54) comprising an electrocaloric material or a supply of multiple sheets (76) of a film comprising an electrocaloric material;
(b) delivering film from the roll or the supply of multiple sheets to a conductive material application station (58);
(c) forming electrodes (14, 16) comprising a patterned disposition of conductive material (60) on the film at the application station to form an electrocaloric article, wherein forming electrodes at the application station comprises applying a patterned disposition of conductive material onto a temporary support and transferring the patterned disposition of conductive material from the temporary support to the film and wherein forming the patterned disposition of conductive material to the temporary support comprises:
(i) selectively applying conductive material to a plurality of areas of the temporary support and the plurality of areas are spaced apart by a dimension of 0.1 times the film thickness to 10 times the film thickness, or
(ii) applying conductive material to a plurality of areas of the temporary support through a patterned mask, and removing the mask, wherein the plurality of areas are spaced apart by a dimension of 0.1 times the film thickness to 10 times the film thickness, or
(iii) selectively etching a conductive material on the temporary support to form a plurality of areas of conductive material spaced apart by a dimension of 0.1 times the film thickness to 10 times the film thickness, or
(iv) applying conductive material to the temporary support, etching the conductive material through unmasked areas of a patterned mask, and removing the mask to form a plurality of areas of conductive material spaced apart by a dimension of 0.1 times the film thickness to 10 times the film thickness,
(d) delivering film from the application station to a take-up roll (64) or an inventory (80) of electrocaloric sheets; and
(e) repeating (b), (c), and (d) to form multiple electrocaloric articles.

2. A method of making electrocaloric articles, comprising
(a) providing a roll (52) of a film (54) comprising an electrocaloric material or a supply of multiple sheets (74) of a film comprising an electrocaloric material;
(b) delivering film from the roll or the supply of multiple sheets to a conductive material application station (58);
(c) forming electrodes (14, 16) comprising a patterned disposition of conductive material (60) on the film at the application station to form an electrocaloric article wherein forming the patterned disposition of conductive material comprises:
(i) selectively applying conductive material to a plurality of areas of the film and the plurality of areas are spaced apart by a dimension of 0.1 times the film thickness to 10 times the film thickness, or
(ii) applying conductive material to a plurality of areas of the film through a patterned mask, and removing the mask wherein the plurality of areas are spaced apart by a dimension of 0.1 times the film thickness to 10 times the film thickness, or
(iii) selectively etching a conductive material on the film to form a plurality of areas of conductive material spaced apart by a dimension of 0.1 times the film thickness to 10 times the film thickness, or
(iv) etching a conductive material on the film through unmasked areas of a patterned mask, and removing the mask to form a plurality of areas of conductive material spaced apart by a dimension of 0.1 times the film thickness to 10 times the film thickness,
(d) delivering film from the application station to a take-up roll (64) or an inventory (80) of electrocaloric sheets; and
(e) repeating (b), (c), and (d) to form multiple electrocaloric articles.

3. The method of claim 1 or 2, wherein the patterned disposition of conductive material (60) includes a power connection (48) configured to connect to an electrical connection between a power source and the electrodes (14, 16).

4. The method of any of claims 1 to 3, wherein forming electrodes (14, 16; 38, 36; 314, 316) at the application station (58) comprises forming first and second electrodes on the same side of the film (54).

5. The method of any of claims 1 to 3, wherein forming electrodes (14. 16) at the application station (58) comprises forming first and second electrodes on opposite sides of the film (54).

6. The method of claims 1 or 2, including applying conductive material (60) includes ion implanted doping, ion implanted electrically active defects, or electron beam induced electrically active defects.

7. The method of any of claims 1 to 6, wherein the plurality of areas on the electrocaloric film surface comprising the conductive material (60) are configured as a plurality of electrically connected linear extensions of conductive material along the film surface separated by spacer areas.

8. The method of claim 1 or 2, wherein the plurality of areas on the electrocaloric film surface comprising the conductive material (60) are spaced apart by a dimension of 0.2 times the film thickness to 5 times the film thickness.

9. The method of claim 1 or 2, wherein the plurality of areas on the electrocaloric film surface comprising the conductive material (60) are spaced apart by a dimension of 0.5 times the film thickness to 2 times the film thickness.

10. A method of making an electrocaloric module, comprising making an electrocaloric article according to any of claims 1-9, and disposing the electrocaloric article in an electrocaloric module (10) comprising the electrocaloric article, a first thermal connection configured to connect to a first thermal flow path (18) between the electrocaloric article and a heat sink (17), a second thermal connection configured to connect to a second thermal flow path (22) between the electrocaloric article and a heat source (20), and a power connection connected to the electrodes (14, 16) and configured to connect to a power source.

11. A method of making an electrocaloric heat transfer system (10), comprising making an electrocaloric module according to claim 10 and connecting the first thermal connection to a first thermal flow path (18) between the electrocaloric article and a heat sink (17), connecting the second thermal connection to a second thermal flow path (22) between the electrocaloric article and a heat source (20), connecting the power connection to a power source, and connecting a controller (24) configured to selectively apply voltage to activate the electrodes (14, 16) in coordination with heat transfer along the first and second thermal flow paths to transfer heat from the heat source to the heat sink.

## Patentansprüche

1. Verfahren zur Herstellung elektrokalorischer Artikel, umfassend
(a) Bereitstellen einer Rolle (52) eines Films (54), der elektrokalorisches Material umfasst, oder einer Zuführung mehrerer Bögen (76) eines Films, der ein elektrokalorisches Material umfasst;
(b) Abgeben des Films von der Rolle oder der Zuführung mehrerer Bögen zu einer Station zum Auftragen (58) eines leitfähigen Materials;
(c) Bilden von Elektroden (14, 16), eine gemusterte Anordnung von leitfähigem Material (60) auf dem Film in der Station zum Auftragen umfassend, zum Bilden eines elektrokalorischen Artikels, wobei das Bilden von Elektroden in der Station zum Auftragen das Auftragen einer gemusterten Anordnung aus leitfähigem Material auf einen vorübergehenden Träger und Übertragen der gemusterten Anordnung aus leitfähigem Material von dem vorübergehenden Träger auf den Film umfasst, und wobei das Bilden der gemusterten Anordnung aus leitfähigem Material auf den vorübergehenden Träger umfasst:
(i) selektiv Auftragen von leitfähigem Material auf eine Vielzahl von Bereichen des vorübergehenden Trägers, und die Vielzahl von Bereichen sind um eine Abmessung von 0,1 mal die Filmdicke bis 10 mal die Filmdicke beabstandet, oder
(ii) Auftragen von leitfähigem Material auf eine Vielzahl von Bereichen des vorübergehenden Trägers durch eine gemusterte Maske hindurch, und Entfernen der Maske, wobei die Vielzahl von Bereichen um eine Abmessung von 0,1 mal die Filmdicke bis 10 mal die Filmdicke beabstandet sind, oder
(iii) selektiv Ätzen eines leitfähigen Materials auf dem vorübergehenden Träger zum Bilden einer Vielzahl von Bereichen aus leitfähigem Material, die um eine Abmessung von 0,1 mal die Filmdicke bis 10 mal die Filmdicke beabstandet sind, oder
(iv) Auftragen von leitfähigem Material auf den vorübergehenden Träger, Ätzen des leitfähigen Materials durch unmaskierte Bereiche einer gemusterten Maske hindurch, und Entfernen der Maske zum Bilden einer Vielzahl von Bereichen aus leitfähigem Material, die um eine Abmessung von 0,1 mal die Filmdicke bis 10 mal die Filmdicke beabstandet sind,
(d) Abgeben des Films von der Station zum Auftragen zu einer Aufwickelrolle (64) oder einem Bestand (80) von elektrokalorischen Bögen; und
(e) Wiederholen von (b), (c), und (d) zum Bilden mehrerer elektrokalorischer Artikel.

2. Verfahren zur Herstellung elektrokalorischer Artikel, umfassend
(a) Bereitstellen einer Rolle (52) eines Films (54), der elektrokalorisches Material umfasst, oder einer Zuführung mehrerer Bögen (74) eines Films, der ein elektrokalorisches Material umfasst;
(b) Abgeben des Films von der Rolle oder der Zuführung mehrerer Bögen zu einer Station zum Auftragen (58) eines leitfähigen Materials;
(c) Bilden von Elektroden (14, 16), eine gemusterte Anordnung aus leitfähigem Material (60) auf dem Film in der Station zum Auftragen umfassend, zum Bilden eines elektrokalorischen Artikels, wobei das Bilden der gemusterten Anordnung aus leitfähigem Material umfasst:
(i) selektiv Auftragen von leitfähigem Material auf eine Vielzahl von Bereichen des Films, und die Vielzahl von Bereichen sind um eine Abmessung von 0,1 mal die Filmdicke bis 10 mal die Filmdicke beabstandet, oder
(ii) Auftragen von leitfähigem Material auf eine Vielzahl von Bereichen des Films durch eine gemusterte Maske hindurch, und Entfernen der Maske, wobei die Vielzahl von Bereichen um eine Abmessung von 0,1 mal die Filmdicke bis 10 mal die Filmdicke beabstandet sind, oder
(iii) selektiv Ätzen eines leitfähigen Materials auf dem Film zum Bilden einer Vielzahl von Bereichen aus leitfähigem Material, die um eine Abmessung von 0,1 mal die Filmdicke bis 10 mal die Filmdicke beabstandet sind, oder
(iv) Ätzen eines leitfähigen Materials auf dem Film durch unmaskierte Bereiche einer gemusterten Maske hindurch, und Entfernen der Maske zum Bilden einer Vielzahl von Bereichen aus leitfähigem Material, die um eine Abmessung von 0,1 mal die Filmdicke bis 10 mal die Filmdicke beabstandet sind,
(d) Abgeben des Films von der Station zum Auftragen zu einer Aufwickelrolle (64) oder einem Bestand (80) von elektrokalorischen Bögen; und
(e) Wiederholen von (b), (c), und (d) zum Bilden mehrerer elektrokalorischer Artikel.

3. Verfahren nach Anspruch 1 oder 2, wobei die gemusterte Anordnung aus leitfähigem Material (60) einen Stromanschluss (48) umfasst, der konfiguriert ist, um an einen elektrischen Anschluss zwischen einer Stromquelle und den Elektroden (14, 16) angeschlossen zu werden.

4. Verfahren nach einem der Ansprüche 1 bis 3, wobei das Bilden von Elektroden (14, 16; 38, 36; 314, 316) in der Station zum Auftragen (58) das Bilden erster und zweiter Elektroden auf der gleichen Seite des Films (54) umfasst.

5. Verfahren nach einem der Ansprüche 1 bis 3, wobei das Bilden von Elektroden (14. 16) in der Station zum Auftragen (58) das Bilden erster und zweiter Elektroden auf gegenüberliegenden Seiten des Films (54) umfasst.

6. Verfahren nach den Ansprüchen 1 oder 2, wobei das Auftragen von leitfähigem Material (60) ionenimplantiertes Dotieren, ionenimplantierte elektrisch aktive Defekte, oder Elektronenstrahl induzierte elektrisch aktive Defekte umfasst.

7. Verfahren nach einem der Ansprüche 1 bis 6, wobei die Vielzahl von Bereichen auf der elektrokalorischen Filmoberfläche, die das leitfähige Material (60) umfassen, als eine Vielzahl von elektrisch angeschlossenen linearen Fortsätzen aus leitfähigem Material entlang der Filmoberfläche konfiguriert sind, die durch Abstandshalterbereiche getrennt sind.

8. Verfahren nach Anspruch 1 oder 2, wobei die Vielzahl von Bereichen auf der elektrokalorischen Filmoberfläche, die das leitfähige Material (60) umfassen, um eine Abmessung von 0,2 mal die Filmdicke bis 5 mal die Filmdicke beabstandet sind.

9. Verfahren nach Anspruch 1 oder 2, wobei die Vielzahl von Bereichen auf der elektrokalorischen Filmoberfläche, die das leitfähige Material (60) umfassen, um eine Abmessung von 0,5 mal die Filmdicke bis 2 Mal die Filmdicke beabstandet sind.

10. Verfahren zur Herstellung eines elektrokalorischen Moduls, umfassend die Herstellung eines elektrokalorischen Artikels nach einem der Ansprüche 1-9, und Anordnen des elektrokalorischen Artikels in einem elektrokalorischen Modul (10), umfassend den elektrokalorischen Artikel, einen ersten Wärmeanschluss, der konfiguriert ist, um an einen ersten Wärmeflusspfad (18) zwischen dem elektrokalorischen Artikel und einem Kühlkörper (17) angeschlossen zu werden, einen zweiten Wärmeanschluss, der konfiguriert ist, um an einen zweiten Wärmeflusspfad (22) zwischen dem elektrokalorischen Artikel und einer Wärmequelle (20) angeschlossen zu werden, und einen Stromanschluss, der an die Elektroden (14, 16) angeschlossen ist, und konfiguriert ist, um an eine Stromquelle angeschlossen zu werden.

11. Verfahren zur Herstellung eines elektrokalorischen Wärmeübertragungssystems (10), umfassend das Herstellen eines elektrokalorischen Moduls nach Anspruch 10, und Anschließen des ersten Wärmeanschlusses an einen ersten Wärmeflusspfad (18) zwischen dem elektrokalorischen Artikel und einem Kühlkörper (17), Anschließen des zweiten Wärmeanschlusses an einen zweiten Wärmeflusspfad (22) zwischen dem elektrokalorischen Artikel und einer Wärmequelle (20), Anschließen des Stromanschlusses an eine Stromquelle, und Anschließen einer Steuereinheit (24), die konfiguriert ist, um selektiv Spannung anzulegen, um die Elektroden (14, 16) in Koordination mit einer Wärmeübertragung entlang des ersten und zweiten Wärmeflusspfades zu aktivieren, um Wärme von der Wärmequelle zum Kühlkörper zu übertragen.

## Revendications

1. Procédé de fabrication d'articles électrocaloriques, comprenant les étapes consistant à
(a) fournir un rouleau (52) d'un film (54) comprenant un matériau électrocalorique ou une alimentation en feuilles multiples (76) d'un film comprenant un matériau électrocalorique ;
(b) distribuer un film depuis le rouleau ou l'alimentation en feuilles multiples vers une station d'application de matériau conducteur (58) ;
(c) former des électrodes (14, 16) comprenant une disposition à motifs de matériau conducteur (60) sur le film au niveau de la station d'application pour former un article électrocalorique, dans lequel l'étape consistant à former des électrodes au niveau de la station d'application comprend l'étape consistant à appliquer une disposition à motifs de matériau conducteur sur un support temporaire et à transférer la disposition à motifs de matériau conducteur depuis le support temporaire vers le film et dans lequel l'étape consistant à former la disposition à motifs de matériau conducteur sur le support temporaire comprend l'étape consistant à :
(i) appliquer sélectivement un matériau conducteur à une pluralité de zones du support temporaire et la pluralité de zones sont espacées par une dimension de 0,1 fois l'épaisseur de film à 10 fois l'épaisseur de film, ou
(ii) appliquer un matériau conducteur à une pluralité de zones du support temporaire par l'intermédiaire d'un masque à motifs, et retirer le masque, dans lequel la pluralité de zones sont espacées par une dimension de 0,1 fois l'épaisseur de film à 10 fois l'épaisseur de film, ou
(iii) graver sélectivement un matériau conducteur sur le support temporaire pour former une pluralité de zones de matériau conducteur espacées par une dimension de 0,1 fois l'épaisseur de film à 10 fois l'épaisseur de film, ou
(iv) appliquer du matériau conducteur au support temporaire, graver le matériau conducteur par l'intermédiaire de zones non masquées d'un masque à motifs, et retirer le masque pour former une pluralité de zones de matériau conducteur espacées par une dimension de 0,1 fois l'épaisseur de film à 10 fois l'épaisseur de film,
(d) distribuer un film depuis la station d'application vers une bobine d'enroulement (64) ou un inventaire (80) de feuilles électrocaloriques ; et
(e) répéter (b), (c) et (d) pour former de multiples articles électrocaloriques.

2. Procédé de fabrication d'articles électrocaloriques, comprenant les étapes consistant à
(a) fournir un rouleau (52) d'un film (54) comprenant un matériau électrocalorique ou une alimentation en feuilles multiples (74) d'un film comprenant un matériau électrocalorique ;
(b) distribuer un film depuis le rouleau ou l'alimentation en feuilles multiples vers une station d'application de matériau conducteur (58) ;
(c) former des électrodes (14, 16) comprenant une disposition à motifs de matériau conducteur (60) sur le film au niveau de la station d'application pour former un article électrocalorique dans lequel l'étape consistant à former la disposition à motifs de matériau conducteur comprend l'étape consistant à :
(i) appliquer sélectivement du matériau conducteur à une pluralité de zones du film et la pluralité de zones sont espacées par une dimension de 0,1 fois l'épaisseur de film à 10 fois l'épaisseur de film, ou
(ii) appliquer du matériau conducteur à une pluralité de zones du film par l'intermédiaire d'un masque à motifs, et retirer le masque, dans lequel la pluralité de zones sont espacées par une dimension de 0,1 fois l'épaisseur de film à 10 fois l'épaisseur de film, ou
(iii) graver sélectivement un matériau conducteur sur le film pour former une pluralité de zones de matériau conducteur espacées par une dimension de 0,1 fois l'épaisseur de film à 10 fois l'épaisseur de film, ou
(iv) graver un matériau conducteur sur le film par l'intermédiaire de zones non masquées d'un masque à motifs, et retirer le masque pour former une pluralité de zones de matériau conducteur espacées par une dimension de 0,1 fois l'épaisseur de film à 10 fois l'épaisseur de film,
(d) distribuer un film depuis la station d'application vers une bobine d'enroulement (64) ou un inventaire (80) de feuilles électrocaloriques ; et
(e) répéter (b), (c) et (d) pour former de multiples articles électrocaloriques.

3. Procédé selon la revendication 1 ou 2, dans lequel la disposition à motifs de matériau conducteur (60) inclut un raccordement d'alimentation (48) configuré pour se raccorder à un raccordement électrique entre une source d'alimentation et les électrodes (14, 16).

4. Procédé selon l'une quelconque des revendications 1 à 3, dans lequel l'étape consistant à former des électrodes (14, 16 ; 38, 36 ; 314, 316) au niveau de la station d'application (58) comprend l'étape consistant à former des première et seconde électrodes sur le même côté du film (54).

5. Procédé selon l'une quelconque des revendications 1 à 3, dans lequel l'étape consistant à former des électrodes (14, 16) au niveau de la station d'application (58) comprend l'étape consistant à former des première et seconde électrodes sur des côtés opposés du film (54).

6. Procédé selon les revendications 1 ou 2, incluant l'étape consistant à appliquer du matériau conducteur (60) inclut un dopage implanté par ions, des défauts électriquement actifs implantés par ions, ou des défauts électriquement actifs induits par un faisceau d'électrons.

7. Procédé selon l'une quelconque des revendications 1 à 6, dans lequel la pluralité de zones sur la surface de film électrocalorique comprenant le matériau conducteur (60) sont configurées comme une pluralité d'extensions linéaires raccordées électriquement de matériau conducteur le long de la surface de film séparée par des zones d'espacement.

8. Procédé selon la revendication 1 ou 2, dans lequel la pluralité de zones sur la surface de film électrocalorique comprenant le matériau conducteur (60) sont espacées par une dimension de 0,2 fois l'épaisseur de film à 5 fois l'épaisseur de film.

9. Procédé selon la revendication 1 ou 2, dans lequel la pluralité de zones sur la surface de film électrocalorique comprenant le matériau conducteur (60) sont espacées par une dimension de 0,5 fois l'épaisseur de film à 2 fois l'épaisseur de film.

10. Procédé de fabrication d'un module électrocalorique, comprenant l'étape consistant à fabriquer un article électrocalorique selon l'une quelconque des revendications 1-9, et l'étape consistant à disposer l'article électrocalorique dans un module électrocalorique (10) comprenant l'article électrocalorique, un premier raccordement thermique configuré pour se raccorder à un premier trajet d'écoulement thermique (18) entre l'article électrocalorique et un dissipateur thermique (17), un second raccordement thermique configuré pour se raccorder à un second trajet d'écoulement thermique (22) entre l'article électrocalorique et une source de chaleur (20), et un raccordement d'alimentation raccordé aux électrodes (14, 16) et configuré pour se raccorder à une source d'alimentation.

11. Procédé de fabrication d'un système de transfert de chaleur électrocalorique (10), comprenant l'étape consistant à fabriquer un module électrocalorique selon la revendication 10 et l'étape consistant à raccorder le premier raccordement thermique à un premier trajet d'écoulement thermique (18) entre l'article électrocalorique et un dissipateur thermique (17), l'étape consistant à raccorder le second raccordement thermique à un second trajet d'écoulement thermique (22) entre l'article électrocalorique et une source de chaleur (20), l'étape consistant à raccorder le raccordement d'alimentation à une source d'alimentation, et l'étape consistant à raccorder un dispositif de commande (24) configuré pour appliquer sélectivement une tension pour activer les électrodes (14, 16) en coordination avec un transfert de chaleur le long des premier et second trajets d'écoulement thermique pour transférer de la chaleur de la source de chaleur au dissipateur thermique.
